Europäisches Patentamt

European Patent Office

Office européen des brevets

(19)

(11) Numéro de publication: **0 110 447**

**B1**

(12) **FASCICULE DE BREVET EUROPEEN**

(45) Date de publication du fascicule du brevet: **07.01.87**

(21) Numéro de dépôt: **83201527.5**

(22) Date de dépôt: **25.10.83**

(51) Int. Cl.⁴: **B 29 C 47/00, H 05 K 13/00, H 01 L 21/56, H 01 L 33/00, B 29 C 63/00**

(54) Procédé d'encapsulation de composants électroniques par extrusion de matière plastique et applications à la fabrication de voyants lumineux et à l'encapsulation de circuits électroniques.

(30) Priorité: **29.10.82 FR 8218253**
**27.06.83 FR 8310571**

(43) Date de publication de la demande:
**13.06.84 Bulletin 84/24**

(45) Mention de la délivrance du brevet:
**07.01.87 Bulletin 87/02**

(84) Etats contractants désignés:
**DE FR GB NL**

(56) Documents cités:
**DE-A-1 614 868**
**FR-A-1 473 478**
**GB-A- 925 062**
**US-A-3 845 552**
**US-A-3 915 780**
**US-A-3 937 644**
**US-A-4 148 856**

(73) Titulaire: **RTC-COMPELEC**
**130, Avenue Ledru-Rollin**
**F-75011 Paris (FR)**
(84) **FR**

(73) Titulaire: **N.V. Philips' Gloeilampenfabrieken**
**Groenewoudseweg 1**
**NL-5621 BA Eindhoven (NL)**
(84) **DE GB NL**

(72) Inventeur: **Sahakian, Diran-Robert**
**Société Civile S.P.I.D. 209, rue de l'Université**
**F-75007 Paris (FR)**

(74) Mandataire: **Charpail, François et al**
**Société Civile S.P.I.D. 209, rue de l'Université**
**F-75007 Paris (FR)**

Courier Press, Leamington Spa, England.

## Description

La présente invention concerne un procédé d'encapsulation de composants électroniques nus se présentant sous forme de bande continue dans laquelle lesdits composants sont alignés selon une première direction, les composants électroniques nus étant destinés à être munis de boîtiers de profil défini, réalisés par extrusion, parallèlement à ladite première direction, d'au moins un matériau plastique à l'aide d'une tête d'extrudeuse dans laquelle sont introduits les composants électroniques.

L'invention trouve une utilisation particulièrement avantageuse dans le domaine général de l'encapsulation des composants électroniques nus, et notamment l'encapsulation des diodes électroluminescentes dans le but de réaliser des voyants lumineux.

Un procédé actuellement connu pour fabriquer, par exemple, des voyants lumineux, consiste à utiliser des godets individuels, dont la partie intérieure reproduit la forme extérieure des voyants et sert de moule au matériau plastique. Chaque godet est rempli manuellement d'une goutte de résine diffusante, puis d'une goutte de résine transparente. Après avoir été trempées dans une résine polymérisables, les diodes électroluminescentes, qui constituent la partie active des voyants, sont placées à l'intérieur des godets, dans la résine transparente. Les résines sont alors polymérisées et les voyants ainsi réalisés sont extraits des godets. Ce procédé connu présente cependant quelques inconvénients. En effet, les opérations de remplissage des godets se faisant manuellement, le prix de revient des voyants fabriqués de cette façon est relativement élevé, d'autant plus que les godets ne peuvent servir qu'un nombre limité de fois et doivent ensuite être remplacés.

Un autre procédé d'encapsulation, concernant des composants se présentant sous forme de chaîne, est décrit dans le brevet des Etats-Unis d'Amérique n° 3 845 552, et correspond ou préambule de la revendication 1. Selon ce procédé connu, les composants sont enrobés par extrusion dans une tête d'extrudeuse. Cependant, ce procédé ne s'applique pas aux composants se présentant sous forme de bande.

Le but de la présente invention est de rémédier à ces inconvénients.

En effet, le procédé d'encapsulation selon la présente invention est notamment remarquable en ce que, le ou les componens electroniques nus constituent une bande comportant des fils rigides de connexion s'étendant dans une deuxième direction sensiblement perpendiculaire à ladite première direction, on insère en continu les composants électroniques nus dans le profil de matériau plastique en introduisant directement ladite bande de composants dans la tête d'extrudeuse de sorte que l'encapsulation se limite aux composants à l'exclusion des fils rigides de connexion, et en ce que, dans une opération finale, on découpe des tranches communes de matériau plastique et de bande de composants de façon à séparer les composants électroniques nus ainsi munis de leurs boîtiers.

Le procédé selon l'invention permet dont de réaliser l'encapsulation des composants de façon quasi automatique et en très grande série, ce qui conduit à une diminution très sensible du coût de production. Un autre avantage de l'invention est d'obtenir non seulement des composants encapsulés individuels mais aussi des barres d'un nombre quelconque de composants.

L'invention est notamment très avantageuse dans le cas de l'encapsulation de diodes électroluminescentes pour la fabrication de voyants lumineux.

De façon à éviter la formation de bulles d'air et l'apparition de contraintes mécaniques, il est prévu, qu'avant introduction dans la tête d'extrudeuse, on réalise un trempage des composants électroniques nus dans une résine polymérisable de trempage, puis qu'on polymérise ladite résine polymérisable de trempage.

L'invention offre aussi l'avantage de permettre de donner aux boîtiers une forme voulue, par exemple ronde dans le cas de certains voyants lumineux. Pour cela, il est prévu qu'en sortie de la tête d'extrudeuse, on fait passer le matériau plastique alors à l'état plastoélastique, dans un outil muni de deux têtes rotatives coplanaires qui donnent au matériau plastique la forme finale désirée des boîtiers. Eventuellement, ledit outil comporte également une troisième tête de formage, perpendiculaire aux deux têtes rotatives coplanaires.

Par la possibilité de coextruder plusieurs matériaux plastiques, le procédé selon l'invention trouve une application particuliérement avantageuse dans la fabrication de voyants lumineux. Dans ce cas en effet, les composants électroniques nus étant des diodes électroluminescentes, lesdits boîtiers sont réalisés par coextrusion d'un premier matériau plastique transparent et d'un deuxième matériau plastique comportant des pigments diffusants.

Enfin, une autre application de l'invention concerne l'encapsulation de circuits électroniques nus; elle consiste à préenrober lesdits circuits électroniques par pulvérisation d'une résine de protection.

Une autre application de l'invention est notamment remarquable en ce que, les composants électroniques nus étant des diodes électroluminescentes, lesdits boîtiers sont réalisés par coextrusion d'un premier matériau plastique transparent et d'un deuxième matériau plastique opaque disposé latéralement de part et d'autre dudit premier matériau plastique transparent.

Ainsi, les boîtiers réalisés de cette manière présentent deux faces opaques permettant de réfléchir et canaliser une partie de la lumière issue des diodes électroluminescentes, vers l'avant des voyants lumineux, donc dans la direction utile.

On peut aussi envisager qu'un troisième matériau plastique comportant des pigments diffusants est coextrudé avec lesdits premier et deuxième matériaux plastiques de façon à constituer l'extrémité des boîtiers.

Enfin, il est prévu que le deuxième matériau plastique opaque est un matériau plastique transparente dopé à l'oxyde de titane.

La description qui va suivre en regard des dessins annexés, donnés à titre d'exemples non limitatifs, fera bien comprendre en quoi consiste l'invention et comment elle peut être réalisée.

La figure 1 donne une représentation synoptique du procédé selon l'invention.

La figure 2 montre en perspective une réalisation de l'invention.

La figure 3 représente en vue de dessus une opération de formage des boîtiers obtenus par le procédé selon l'invention.

La figure 4 montre en perspective une application du procédé selon l'invention à des circuits électroniques.

La figure 5 montre en perspective un deuxième mode de réalisation de l'invention.

La figure 6 est une coupe d'un voyant lumineux obtenu à partir du mode de réalisation de la figure 5.

La figure 7 montre en perspective un autre mode.

La figure 8 est une coupe d'un voyant lumineux obtenu à partir du mode de réalisation de la figure 7.

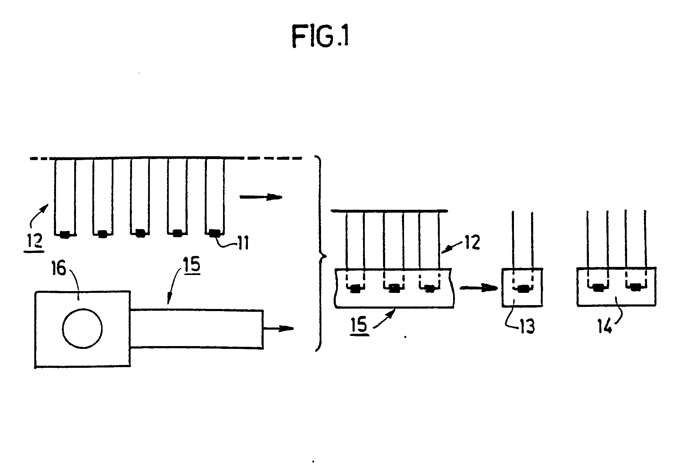

La figure 1 donne sous forme synoptique les différentes étapes d'un procédé d'encapsulation de composants électroniques nus 11 se présentant sous forme de bande continue dans laquelle lesdits composants 11 sont alignés selon une première direction, les composants électroniques nus 11 étant destinés à être munis de boîtiers 13, 14 de profil défini, réalisés par extrusion, parallèlement à ladite première direction, d'au moins un matériau plastique 15 à l'aide d'une tête 16 d'extrudeuse. Conformément à la figure 1 le procédé d'encapsulation est réalisé pour des composants avec des fils rigides de connexion s'étendant dans une deuxième direction sensiblement perpendiculaire à la première direction dans laquelle les composants sont alignés. Les composants électroniques nus 11 sont insérés et immobilisés en continu dans ledit profil de sorte que l'encapsulation se limite aux composants 11 à l'exclusion des fils rigides de connexion. Puis, dans une opération finale, on découpe des tranches communes de matériau plastique 15 extrudé et de bande 12 de composants de façon à séparer les composants électroniques nus 11 ainsi munis de leurs boîtiers 13, 14.

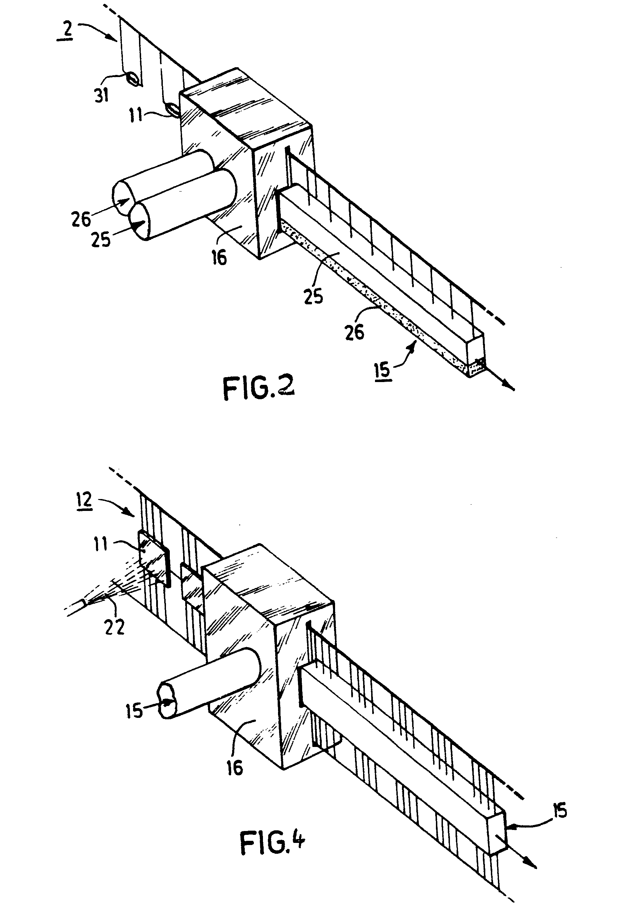

La figure 2 montre un mode de réalisation de l'invention dans lequel on insère en continu les composants électroniques nus 11 dans le profil de matériau plastique 15 en introduisant directement ladite bande 12 de composants dans la tête 16 d'extrudeuse, l'immobilisation desdits composants 11 étant réalisée par enrobage dans le matériau plastique lui-même. Dans ce mode de réalisation, on peut également, avant introduction dans la tête 16 d'extrudeuse, réaliser un trempage des composants électroniques nus 11 dans une résine polymérisable 31 de trempage, éventuellement photopolymérisable, qui est ensuite polymérisée.

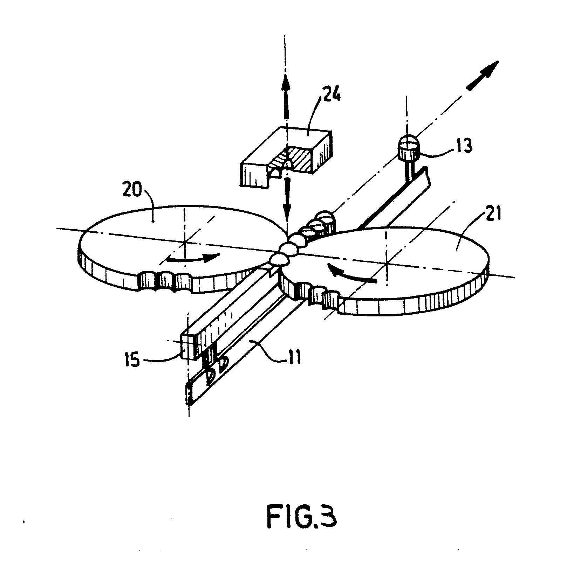

Un avantage du mode de réalisation de l'invention monté à la figure 2 est qu'il permet de pouvoir former à volonté les boîtiers des composants 11. Comme l'illustre la figure 3, sur un exemple de boîtiers 13 ronds, on extrude le matériau plastique 15 selon un profil arrondi, puis, en sortie de la tête 16 d'extrudeuse, on fait passer le matériau plastique 15, alors à l'état plastoélastique, dans un outil muni de deux têtes rotatives 20, 21, qui donnent au matériau plastique la forme finale cylindrique dérisée pour les boîtiers 13. Afin de réaliser la calotte arrondie des boîtiers, l'outil comporte également une troisième tête 24 de formage, perpendiculaire aux deux têtes rotatives coplanaires 20, 21.

Le procédé décrit aux figures 1, 2, et 3 s'applique en particulier à l'encapsulation de diodes électroluminescentes dans le but de fabriquer des voyants lumineux avec l'avantage de pouvoir réaliser les boîtiers de voyants par coextrusion d'une premier matériau plastique transparent 25 et d'un deuxième matériau plastique 26 comportant des pigments diffusants.

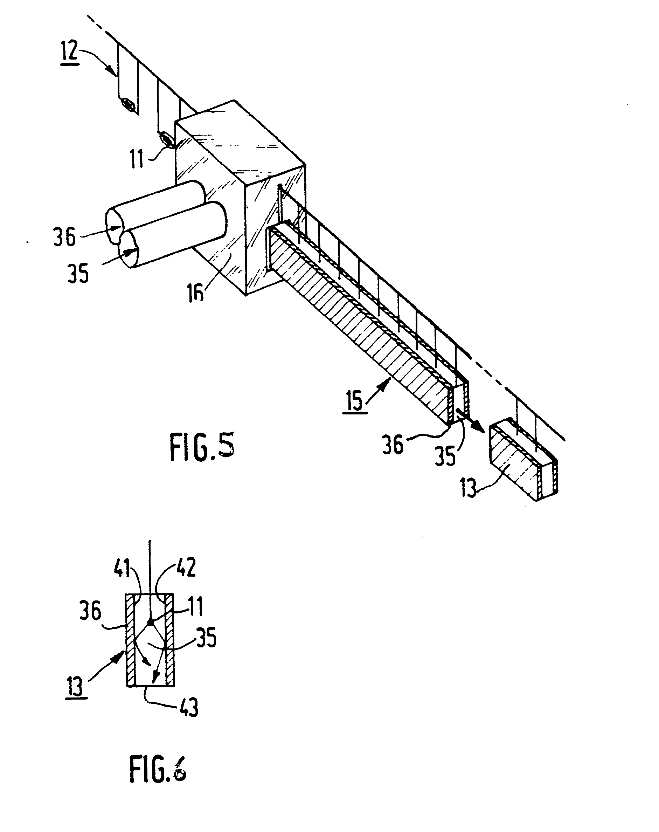

Plus généralement, le procédé d'encapsulation selon l'invention trouve des applications variées en fonction des composants électroniques nus à encapsuler. Dans le cas des circuits intégrés nus, on peut envisager, comme le montre la figure 4, de préenrober lesdits circuits intégrés 11 par pulvérisation d'un résine 22 de protection.

En plus des composants électroniques actifs (diodes de puissance, photocoupleurs, etc. ...), le procédé selon l'invention s'applique également aux composants passifs comme les résistances ou les condensateurs.

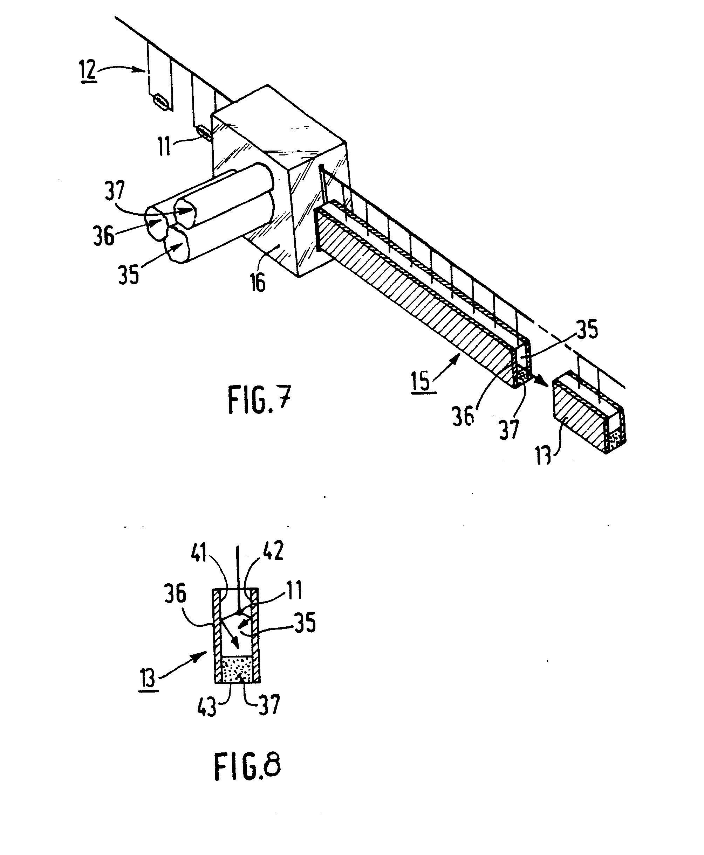

La figure 5 montre, en perspective, une application à la fabrication de voyants lumineux d'un procédé d'encapsulation de composants électroniques nus 11 se présentant sous forme de bande continue 12, et destinés à être munis de boîtiers 13 de forme définie, réalisés en au moins un matériau plastique 15. Comme on peut le voir à la figure 5, les composants électroniques nus 11 sont des diodes électroluminescentes, et les boîtiers 13 sont réalisés par coextrusion d'un premier matériau plastique transparent 35 et d'un deuxième matériau plastique opaque 36 disposé latéralement de part et d'autre dudit premier matériau plastique transparent. Ainsi que le montre la coupe de la figure 6, les rayons lumineux issus de la diode électroluminescente 11 qui atteignent les faces 41, 42, recouvertes du matériau plastique opaque 36 sont réfléchis vers la face de sortie 43 du voyant lumineux dont le rendement est ainsi augmenté.

Avantageusement, ledit matériau plastique opaque 36 est un matériau plastique transparent, éventuellement identique au matériau plastique transparent 35, dopé à l'oxyde de titane.

La figure 7 montre un autre mode de réalisation dans lequel un troisième matériau plastique 37 comportant des pigments diffusants est coextrudé avec lesdits premier 35 et deuxième 36 matériaux plastiques de façon à constituer l'extrémité des boîtiers 13.

La figure 8 montre que les rayons lumineux qui sont réfléchis par le matériau plastique opaque 36 sont dirigés vers la face de sortie 43 du voyant lumineux après traversée du matériau plastique diffusant 37.

**Revendications**

1. Procédé d'encapsulation de composants électroniques nus (11) se présentant sous forme de chaîne continue dans laquelle lesdits composants (11) sont alignés selon une première direction, les composants électroniques nus (11) étant destinés à être de boîtiers (13, 14) de profil défini, réalisés par extrusion, parallèlement à ladite première direction, d'au moins un matériau plastique (15) à l'aide d'une tête (16) d'extrudeuse dans laquelle sont introduits les composants électroniques (11), caractérisé en ce que, le ou les composants électroniques nus constituent une bande comportant des fils rigides de connexion s'étendant dans une deuxième direction sensiblement perpendiculaire à la première direction, on insère en continu les composants électroniques nus (11) dans le profil de matériau plastique (15) en introduisant directement ladite bande (12) de composants dans la tête (16) d'extrudeuse de sorte que l'encapsulation se limite aux composants (11) à l'exclusion des fils rigides de connexion, et en ce que, uns une opération finale, on découpe des tranches communes de matériau plastique (15) extrudé et de bande (12) de composants de façon à séparer les composants électroniques nus (11) ainsi munis de leurs boîtiers (13, 14).

2. Procédé d'encapsulation selon la revendication 1, caractérisé en ce qu'avant introduction dans la tête (16) d'extrudeuse, on réalise un trempage des composants électroniques nus (11) dans une résine polymérisable de trempage, puis qu'on polymérise ladite résine polymérisable (31) de trempage.

3. Procédé d'encapsulation selon la revendication 2, caractérisé en ce que ladite résine polymérisable (31) de trempage est une résine photopolymérisable.

4. Procédé d'encapsulation selon la revendication 3, caractérisé en ce qu'en sortie de la tête (16) d'extrudeuse, on fait passer le matériau plastique (15), alors à l'état plastoélastique, dans un outil muni de deux têtes rotatives (20, 21) coplanaires qui donnent au matériau plastique la forme finale désirée des boîtiers (13).

5. Procédé d'encapsulation selon la revendication 4, caractérisé en ce que ledit outil comporte également une troisième tête (24) de formage, perpendiculaire aux deux têtes rotatives coplanaires (20, 21).

6. Application du procédé d'encapsulation selon l'une quelconque des revendications 1 à 5 à la fabrication de voyants lumineux, caractérisée en ce que, les composants électroniques nus (11) étant des diodes électroluminescentes, lesdits boîtiers (13, 14) sont réalisés par coextrusion d'un premier matériau plastique transparent (25) et d'un deuxième matériau plastique (26) comportant des pigments diffusants.

7. Application du procédé d'encapsulation selon l'une des revendications 2 à 5 à des circuits électroniques nus (11), caractérisée en ce que lesdits circuits électroniques sont préenrobés par pulvérisation d'une résine de protection (22).

8. Procédé d'encapsulation selon la revendication 1, caractérisé en ce que, les composants électroniques nus (11) étant des diodes électroluminescentes, lesdits boîtiers (13) sont réalisés par coextrusion d'un premier matériau plastique transparent (35) et d'un deuxième matériau plastique opaque (36) disposé latéralement de part et d'autre dudit premier matériau plastique transparent.

9. Procédé selon la revendication 8, caractérisé en ce qu'un troisième matériau plastique (37) comportant des pigments diffusants est coextrudé avec lesdits premier (35) et deuxième (36) matériaux plastiques de façon à constituer l'extrémité des boîtiers (13).

10. Procédé selon l'une quelconque des revendications 8 et 9, caractérisé en ce que le deuxième matériau plastique opaque (36) est un matériau plastique transparent dopé à l'oxyde de titane.

**Patentansprüche**

1. Verfahren zum Umhüllen unbedeckter elektronischer Elemente (11), die in Form eines Streifens angeboten werden, in dem die genannten Elemente (11) entsprechend einer ersten Richtung fluchtend liegen, wobei die unbedeckten elektronischen Elemente (11) mit Gehäusen (13, 14) mit einem bestimmten Profil versehen werden sollen, die im Fliesspressverfahren parallel zu der genannten ersten Richtung mit Hilfe eines Fliesspresskopfes, in den die elektronischen Elemente (11) eingeführt worden sind, aus mindestens einem Kunststoff hergestellt sind, dadurch gekennzeichnet, dass das unbedeckte Element bzw. die unbedeckten elektronischen Elemente einen Streifen mit festen Verbindungsdrähten bilden, die sich in einer zweiten Richtung nahezu senkrecht zu der genannten ersten Richtung erstrecken, die unbedeckten elektronischen Elemente (11) dadurch kontinuierlich in das Kunststoffprofil (15) eingeführt werden, dass der genannte Streifen (12) mit den Elementen unmittelbar in den Fliesspresskopf (16) eingeführt wird, so dass die Umhüllung sich mit Ausnahme der festen Verbindungsdrähte auf die Elemente (11) beschränkt und dass in einem abschliessenden Vorgang Scheiben (15), die das fliessgepresste Kunststoffmaterial sowie den Elementestreifen (12) enthalten, derart abgeschnitten werden, dass die unbedeckten, auf diese Weise mit Gehäusen (13, 14) versehenen elektronischen Elemente (11) gestrennt werden.

2. Verfahren zum Umhüllen nach Anspruch 1, dadurch gekennzeichnet, dass vor dem Einführen in den Fliesspresskopf (16) unbedeckte elektronische Elemente (11) in ein polymerisierbares Tauchharz getaucht werden, wonach das genannte polymerisierbare Tauchharz (31) polymerisiert wird.

3. Verfahren zum Umhüllen nach Anspruch 2, dadurch gekennzeichnet, dass das genannte polymerisierbare Tauchharz (31) ein lichtpolymerisierbares Harz ist.

4. Verfahren zum Umhüllen nach Anspruch 3, dadurch gekennzeichnet, dass an dem Ausgang des Fliesspresskopfes (16) der Kunststoff (15) in einem plastoelastischen Zustand in ein Werkzeug eingeführt wird, das mit zwei planparallelen sich drehenden Köpfen (20, 21) versehen ist, durch die der Kunststoff die gewünschte endgültige Form der Gehäuse (13) erhält.

5. Verfahren zum Umhüllen nach Anspruch 4, dadurch gekennzeichnet, dass das genannte Werkzeug ebenfalls mit einem dritten Formkopf (24) versehen ist, der sich senkrecht zu den beiden planparallelen Köpfen (20, 21) erstreckt.

6. Anwendung des Verfahrens zum Umhüllen nach einem der Ansprüche 1 bis 5 zum Herstellen von Leuchtanzeigeelementen, dadurch gekennzeichnet, dass wenn die unbedeckten elektronischen Elemente (11) Leuchtdioden sind, die genannten Gehäuse (13, 14) in einem Zusammenfliesspressvorgang eines ersten transparenten Kunststoffes (25) und eines zweiten lichtstreuende Pigmente enthaltenden Kunststoffes (26) hergestellt werden.

7. Anwendung des Verfahrens zum Umhüllen nach einem der Ansprüche 2 bis 5 für unbedeckte elektronische Schaltungselemente (11), dadurch gekennzeichnet, dass die genannten elektronischen Schaltungselemente zuvor durch Zerstäubung eines Schutzharzes (22) ummantelt worden sind.

8. Verfahren zum Umhüllen nach Anspruch 1, dadurch gekennzeichnet, dass wenn die unbedeckten elektronischen Elemente (11) Leichtdioden sind, die genannten Gehäuse (13) in einem Zusammenfliesspressvorgang eines ersten transparenten Kunststoffes (35) und eines zweiten an beiden Seiten des genannten ersten transparenten Kunststoffes angebrachten undurchsichtigen Kunststoffes (36) hergestellt werden.

9. Verfahren nach Anspruch 8, dadurch gekennzeichnet, dass ein dritter lichtstreuende Pigmente enthaltender Kunststoff (37) mit dem genannten ersten (35) und zweiten (36) Kunststoff zusammen fliessgepresst wird, dass das Ende der Gehäuse (13) gebildet wird.

10. Verfahren nach einem der Ansprüche 8 und 9, dadurch gekennzeichnet, dass der genannte undurchsichtige Kunststoff (36) ein mit Titanoxid dotierter transparenter Kunststoff ist.

**Claims**

1. A method of encapsulating bare electronic components (11) taking the form of a continuous chain in which the said components (11) are aligned in a first direction, the bare electronic components (11) being intended to be provided with envelopes (13, 14) of a defined profile obtained by extrusion parallel to the said first direction of at least one plastic material (15) by means of an extrusion head (16), into which the electronic components (11) are introduced, characterized in that the electronic component(s) constituting a strip comprising rigid connection wires extending in a second direction substantially at right angles to the first direction, the bare electronic components (11) are continuously inserted into the profile of plastic material (15) by directly introducing the said strip (12) of components into the extrusion head (16) so that the encapsulation is limited to the components (11) exclusive of the rigid connection wires, and in that in a final operation common sections of extruded plastic material (15) and of strips (12) of components are cut so that the bare electronic components (11) thus provided with their envelopes (13, 14) are severed.

2. An encapsulation method as claimed in Claim 1, characterized in that, before being introduced into the extrusion head (16), the bare electronic components (11) are cured in a polymerizable curing resin, after which the said polymerizable curing resin (31) is polymerized.

3. An encapsulation method as claimed in Claim 2, characterized in that the said polymerizable curing resin (31) is a photopolymerizable resin.

4. An encapsulation method as claimed in Claim 3, characterized in that at the exit of the extrusion head (16) the plastic material (15), which is then in the plasto-elastic state, is caused to pass into a tool provided with two coplanar rotatable heads (20, 21), which give the plastic material the ultimate desired form of the envelopes (13).

5. An encapsulation method as claimed in Claim 4, characterized in that the said tool further comprises a third forming head (24) at right angles to the two coplanar rotatable heads (20, 21).

6. An application of the encapsulation method as claimed in any one of Claims 1 to 5 for the manufacture of light-emitting elements, characterized in that the bare electronic components (11) being electroluminescent diodes, the said envelopes (13, 14) are obtained by co-extrusion of a first plastic transparent material (25) and of a second plastic material (26) containing diffusing pigments.

7. An application of the encapsulation method as claimed in any one of Claims 2 to 5 for bare electronic circuits (11) characterized in that the said electronic circuits are pre-enveloped by pulverization of a protecting resin (22).

8. An encapsulation method as claimed in Claim 1, characterized in that the electronic components (11) being light-emitting diodes, the said envelopes (13) are obtained by co-extrusion of a first plastic transparent material (35) and of a second plastic opaque material (36) disposed laterally on either side of the said first plastic transparent material.

9. A method as claimed in Claim 3, characterized in that a third plastic material (37) containing diffusing pigments is co-extruded with the said first and second plastic materials (35 and 36 respectively) in such a manner that the end of the envelopes (13) is formed.

10. A method as claimed in any one of the Claims 8 and 9, characterized in that the second plastic opaque material (36) is a transparent plastic material doped with titanium oxide.

# FIG.1

FIG.2

FIG.4

FIG.3

FIG.5

FIG.6

FIG.7

FIG.8